(19)

Europäisches Patentamt

European Patent Office

Office européen des brevets

(11) **EP 4 235 666 A1**

(12) **EUROPEAN PATENT APPLICATION**

(43) Date of publication:
**30.08.2023 Bulletin 2023/35**

(21) Application number: **23157510.1**

(22) Date of filing: **20.02.2023**

(51) International Patent Classification (IPC):
**G11B 20/12** (2006.01)  **G06F 3/06** (2006.01)
**G06F 11/10** (2006.01)  **G11B 17/22** (2006.01)
**G11B 27/00** (2006.01)

(52) Cooperative Patent Classification (CPC):
**G11B 20/1201; G06F 3/06; G06F 11/1076;
G11B 17/22; G11B 27/002**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.02.2022 JP 2022027166**

(71) Applicant: **FUJIFILM Corporation
Tokyo 106-8620 (JP)**

(72) Inventors:
 • **OISHI, Yutaka
  Tokyo, 106-8620 (JP)**
 • **KONDO, Michitaka
  Tokyo, 106-8620 (JP)**
 • **OTSUKA, Misaki
  Tokyo, 106-8620 (JP)**
 • **MASUDA, Yuko
  Tokyo, 106-8620 (JP)**

(74) Representative: **Klunker IP
Patentanwälte PartG mbB
Destouchesstraße 68
80796 München (DE)**

(54) **INFORMATION PROCESSING APPARATUS, INFORMATION PROCESSING METHOD, AND INFORMATION PROCESSING PROGRAM**

(57)    An information processing apparatus executes processing of making sizes of a plurality of pieces of data the same by adding dummy data to data other than data having a maximum size among the plurality of pieces of data, generates parity data based on the plurality of pieces of data to which the dummy data is added, and selects the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

EP 4 235 666 A1

**Description**

**BACKGROUND OF THE INVENTION**

1. Field of the Invention

The present disclosure relates to an information processing apparatus, an information processing method, and an information processing program.

2. Description of the Related Art

JP2021-117772A discloses a technique of generating parity data from a plurality of pieces of data and recording the plurality of pieces of data and the parity data on magnetic tapes different from each other.
JP2015-143952A discloses a technique of making a plurality of pieces of data the same size in a case of generating parity data from the plurality of pieces of data by adding dummy data to data other than data having a maximum size among the plurality of pieces of data having sizes different from each other.

**SUMMARY OF THE INVENTION**

It is preferable to reduce a difference in a time required for recording data on each of a plurality of magnetic tapes in a case where a plurality of pieces of data and parity data generated from the plurality of pieces of data are recorded on the plurality of magnetic tapes. The techniques described in JP2021-117772A and JP2015-143952A do not consider a time required for recording data on each of a plurality of magnetic tapes in a case where a plurality of pieces of data and parity data generated from the plurality of pieces of data are recorded on the plurality of magnetic tapes.
The present disclosure has been made in view of the above circumstances, and an object of the present disclosure is to provide an information processing apparatus, an information processing method, and an information processing program capable of reducing a difference in a time required for recording data on each of a plurality of magnetic tapes in a case where a plurality of pieces of data and parity data generated from the plurality of pieces of data are recorded on the plurality of magnetic tapes.
According to an aspect of the present disclosure, there is provided an information processing apparatus that performs a control of recording a plurality of pieces of data on a plurality of magnetic tapes, the apparatus including: at least one processor, in which the processor is configured to execute processing of making sizes of the plurality of pieces of data the same by adding dummy data to data other than data having a maximum size among the plurality of pieces of data, generate parity data based on the plurality of pieces of data to which the dummy data is added, and select the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.
In the information processing apparatus according to the aspect of the present disclosure, the processor may be configured to select the magnetic tapes as the recording destinations of the plurality of pieces of data and the parity data from the plurality of magnetic tapes such that a difference in a size of the parity data to be recorded on each of the plurality of magnetic tapes is minimized.
Further, in the information processing apparatus according to the aspect of the present disclosure, a plurality of combinations of the plurality of pieces of data and the parity data may exist, and the processor may be configured to select the magnetic tapes different from each other as recording destinations of each of the plurality of pieces of data and the parity data in the same set, and select the magnetic tapes as recording destinations of each of pieces of the parity data such that a difference in a total size of the pieces of the parity data to be recorded on each of the plurality of magnetic tapes is minimized.
Further, in the information processing apparatus according to the aspect of the present disclosure, the processor may be configured to perform a control of recording only the data among the data and the dummy data added to the data in a case of performing the control of recording the data on the selected magnetic tapes.
Further, in the information processing apparatus according to the aspect of the present disclosure, the processor may be configured to select the magnetic tapes as the recording destinations of the plurality of pieces of data and the parity data from the plurality of magnetic tapes such that a difference in a size of the dummy data to be recorded on each of the plurality of magnetic tapes is minimized.
Further, in the information processing apparatus according to the aspect of the present disclosure, a plurality of combinations of the plurality of pieces of data and the parity data may exist, and the processor may be configured to select the magnetic tapes different from each other as recording destinations of each of the plurality of pieces of data and the parity data in the same set, and select the magnetic tapes as recording destinations of each of the plurality of pieces of data and the parity data from the plurality of magnetic tapes such that a difference in a total size of pieces of the dummy data to be recorded on each of the plurality of magnetic tapes is minimized.

Further, in the information processing apparatus according to the aspect of the present disclosure, the data to be recorded on the magnetic tapes may be a packed object obtained by grouping a plurality of objects including data and metadata related to the data.

Further, according to another aspect of the present disclosure, there is provided an information processing method executed by a processor of an information processing apparatus that includes at least one processor and performs a control of recording a plurality of pieces of data on a plurality of magnetic tapes, the method including: executing processing of making sizes of the plurality of pieces of data the same by adding dummy data to data other than data having a maximum size among the plurality of pieces of data; generating parity data based on the plurality of pieces of data to which the dummy data is added; and selecting the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

Further, according to still another aspect of the present disclosure, there is provided an information processing program for an information processing apparatus including at least one processor and performing a control of recording a plurality of pieces of data on a plurality of magnetic tapes, the information processing program for causing the processor to execute a process including: executing processing of making sizes of the plurality of pieces of data the same by adding dummy data to data other than data having a maximum size among the plurality of pieces of data; generating parity data based on the plurality of pieces of data to which the dummy data is added; and selecting the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

According to the present disclosure, it is possible to reduce a difference in a time required for recording data on each of a plurality of magnetic tapes in a case where a plurality of pieces of data and parity data generated from the plurality of pieces of data are recorded on the plurality of magnetic tapes.

## BRIEF DESCRIPTION OF THE DRAWINGS

Fig. 1 is a block diagram illustrating an example of a configuration of an information processing system.
Fig. 2 is a diagram for explaining an object.
Fig. 3 is a diagram for explaining a packed object.
Fig. 4 is a block diagram illustrating an example of a hardware configuration of an information processing apparatus.
Fig. 5 is a block diagram illustrating an example of a functional configuration of the information processing apparatus.
Fig. 6 is a diagram for explaining dummy data addition processing.
Fig. 7 is a diagram for explaining processing of generating parity data.
Fig. 8 is a diagram for explaining a plurality of sets of packed objects and parity data.
Fig. 9 is a diagram for explaining processing of selecting magnetic tapes as recording destinations of pieces of data.
Fig. 10 is a diagram for explaining processing of selecting magnetic tapes as recording destinations of pieces of data.
Fig. 11 is a flowchart illustrating an example of data recording processing.
Fig. 12 is a diagram for explaining processing of selecting magnetic tapes as recording destinations of pieces of data according to a modification example.

## DESCRIPTION OF THE PREFERRED EMBODIMENTS

Hereinafter, an example of an embodiment for performing a technique according to the present disclosure will be described in detail with reference to the drawings.

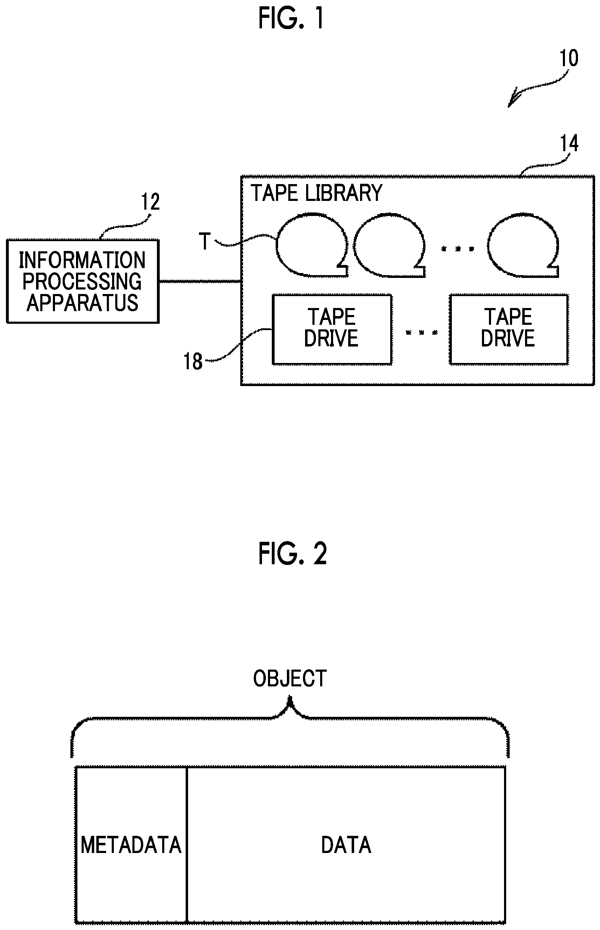

First, a configuration of an information processing system 10 according to the present embodiment will be described with reference to Fig. 1. As illustrated in Fig. 1, the information processing system 10 includes an information processing apparatus 12 and a tape library 14. Examples of the information processing apparatus 12 include a server computer and the like.

The tape library 14 includes a plurality of slots (not illustrated) and a plurality of tape drives 18, and each slot includes a magnetic tape T as an example of a recording medium. Each tape drive 18 is connected to the information processing apparatus 12. The tape drive 18 writes or reads data to or from the magnetic tape T under a control of the information processing apparatus 12. Examples of the magnetic tape T include a linear tape-open (LTO) tape.

In a case where the information processing apparatus 12 writes or reads data to or from the magnetic tape T, the magnetic tape T as a write target or a read target is loaded from the slot into a predetermined tape drive 18. In a case where data is written or read to and from the magnetic tape T loaded into the tape drive 18, the magnetic tape T is unloaded from the tape drive 18 into the slot in which the magnetic tape T is originally included.

In the present embodiment, as illustrated in Fig. 2 as an example, as a unit for handling data to be recorded in the magnetic tape T, an example of an embodiment in which an object including data to be saved by a user such as document data and image data and metadata related to the data is applied will be described. In the example of Fig. 2, the metadata is referred to as "meta". A storage system that handles the object is called an object storage system. The metadata includes, for example, identification information of an object such as an object key, and attribute information such as an object name, a data size, and a time stamp. The recording order of the data and the metadata when recording the object in the magnetic tape T is not particularly limited, and may be an order of the metadata and the data or an order of the data and the metadata.

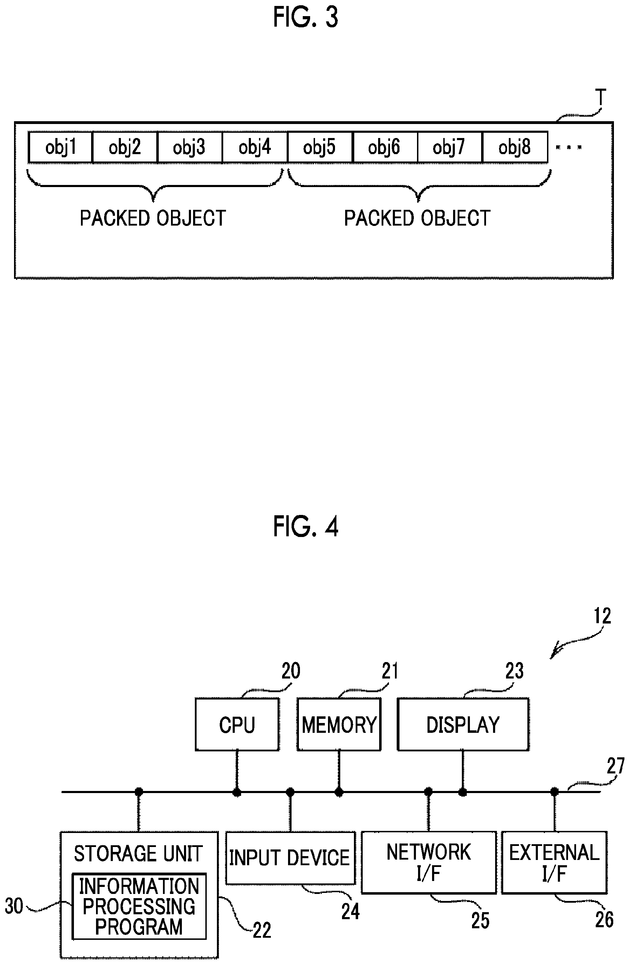

In addition, in the present embodiment, as illustrated in Fig. 3 as an example, a plurality of objects are recorded on the magnetic tape T in units of objects (hereinafter, referred to as a "packed object") grouped according to a predetermined rule (hereinafter, referred to as a "packing rule"). This aims to reduce overhead due to issuance of a command for instructing the tape drive 18 to record an object in a case where the information processing apparatus 12 records the object on the magnetic tape T. The packed object is an example of data to be recorded on the magnetic tape T according to the disclosed technique. "Obj" in Fig. 3 represents an object. Fig. 3 illustrates an example in which one packed object includes four objects. On the other hand, the present embodiment is not limited thereto. One packed object may include three or less objects, or may include five or more objects. In addition, the number of objects included in the packed object may not be the same.

Examples of the packing rule include a rule for grouping a plurality of objects including pieces of data having the same extension into the same packed object and a rule for grouping a plurality of objects that are likely to be read at the same time into the same packed object. In addition, examples of the packing rule include a rule for grouping a plurality of objects into one packed object such that a size of one packed object is equal to or larger than a predetermined lower limit value and is smaller than a predetermined upper limit value. In addition, examples of the packing rule include a rule for grouping a plurality of objects into one packed object such that the number of objects included in one packed object is equal to or larger than a predetermined lower limit value and is smaller than a predetermined upper limit value. In addition, a plurality of packing rules may be combined.

Next, a hardware configuration of the information processing apparatus 12 according to the present embodiment will be described with reference to Fig. 4. As illustrated in Fig. 4, the information processing apparatus 12 includes a central processing unit (CPU) 20, a memory 21 as a temporary memory area, and a non-volatile storage unit 22. Further, the information processing apparatus 12 includes a display 23 such as a liquid crystal display, an input device 24 such as a keyboard and a mouse, a network interface (I/F) 25 connected to a network, and an external I/F 26 to which each tape drive 18 is connected. The CPU 20, the memory 21, the storage unit 22, the display 23, the input device 24, the network I/F 25, and the external I/F 26 are connected to a bus 27. The CPU 20 is an example of a processor.

The storage unit 22 is realized by a hard disk drive (HDD), a solid state drive (SSD), a flash memory, or the like. An information processing program 30 is stored in the storage unit 22 as a storage medium. The CPU 20 reads the information processing program 30 from the storage unit 22, develops the read information processing program 30 in the memory 21, and executes the developed information processing program 30.

On the other hand, the information processing apparatus 12 according to the present embodiment receives the data and the metadata transmitted from an external apparatus such as a user terminal. For transmission of the data from the external apparatus, for example, a hypertext transfer protocol (HTTP) application programming interface (API) provided from the information processing system 10 is used.

In this case, for example, the data to be transmitted by a user is included in a body portion of HTTP, and the metadata related to the data is included in a header portion of HTTP. The information processing apparatus 12 stores the object associated with the received data and the received metadata in the storage unit 22. The information processing apparatus 12 has a function of performing a control of generating a packed object based on the plurality of objects stored in the storage unit 22 and recording a plurality of generated packed objects on the plurality of magnetic tapes T.

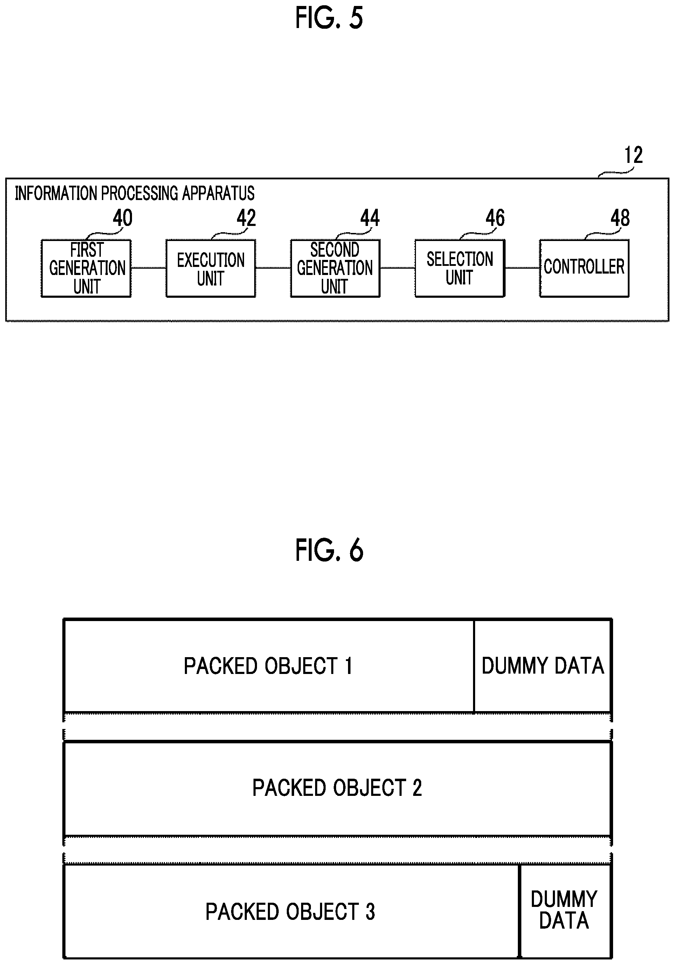

Next, a functional configuration of the information processing apparatus 12 according to the present embodiment will be described with reference to Fig. 5. As illustrated in Fig. 5, the information processing apparatus 12 includes a first generation unit 40, an execution unit 42, a second generation unit 44, a selection unit 46, and a controller 48. In a case where the CPU 20 executes the information processing program 30, the information processing apparatus 12 functions as the first generation unit 40, the execution unit 42, the second generation unit 44, the selection unit 46, and the controller 48.

The first generation unit 40 generates a packed object obtained by grouping the plurality of objects stored in the storage unit 22 according to a packing rule, and stores the generated packed object in the storage unit 22. The first generation unit 40 sequentially generates the packed objects, and the plurality of packed objects are stored in the storage unit 22.

The execution unit 42 performs processing of making the sizes of the plurality of packed objects the same size by adding dummy data to the packed objects other than the packed object having a maximum size among the plurality of packed objects stored in the storage unit 22 (hereinafter, referred to as "dummy data addition processing"). Examples of the dummy data include data padded with 0, data padded with 1, and the like. In addition, the dummy data may be data represented by a bit string in which 0s and 1s are arranged according to a specific rule, such as data in which 0s and 1s are alternately repeated.

In the present embodiment, as illustrated in Fig. 6 as an example, the execution unit 42 executes the dummy data addition processing by using three packed objects as one set. The execution unit 42 may set two packed objects as one set, or may set four or more packed objects as one set. In Fig. 6, "dummy" represents dummy data. Further, in Fig. 6, a horizontal length of each rectangle represents a data size of the rectangle. That is, in the example of Fig. 6, among the three packed objects, the "packed object 2" is a packed object having a maximum size.

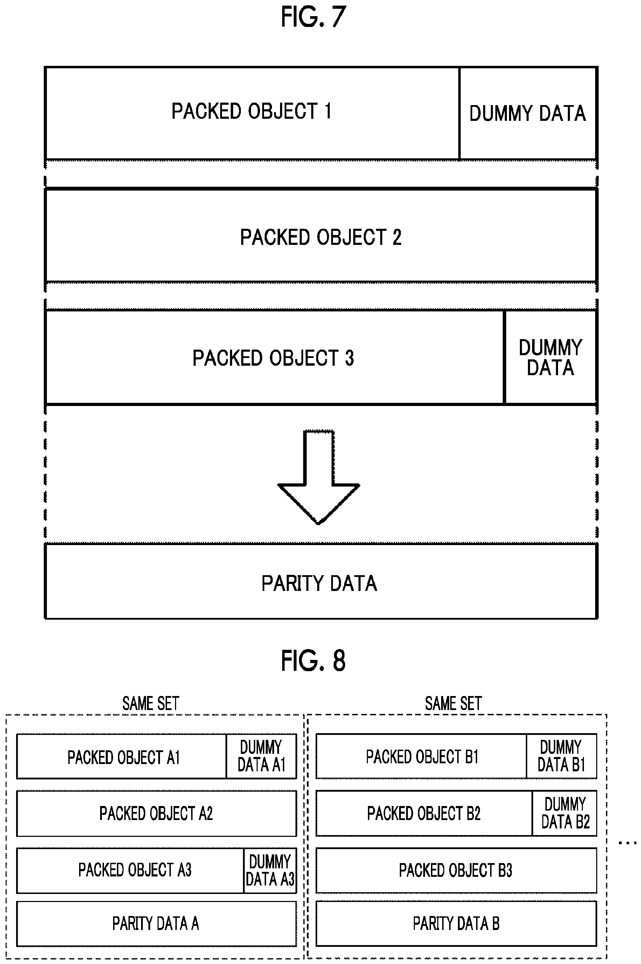

The second generation unit 44 generates parity data based on the plurality of packed objects to which the dummy data is added by the execution unit 42. In the present embodiment, as illustrated in Fig. 7 as an example, the second generation unit 44 generates parity data having the same size as the three packed objects from the three packed objects after execution of the dummy data addition processing by the execution unit 42. In the packed objects after execution of the dummy data addition processing, the packed object having the maximum size means the packed object itself, and the packed object other than the packed object having the maximum size means the packed object to which the dummy data is added. The parity data according to the present embodiment is a redundant code capable of recovering, even in a case where one packed object of the three packed objects is lost, the one packed object from the remaining two packed objects and the parity data. In Fig. 7, a horizontal length of each rectangle also represents a data size of the rectangle.

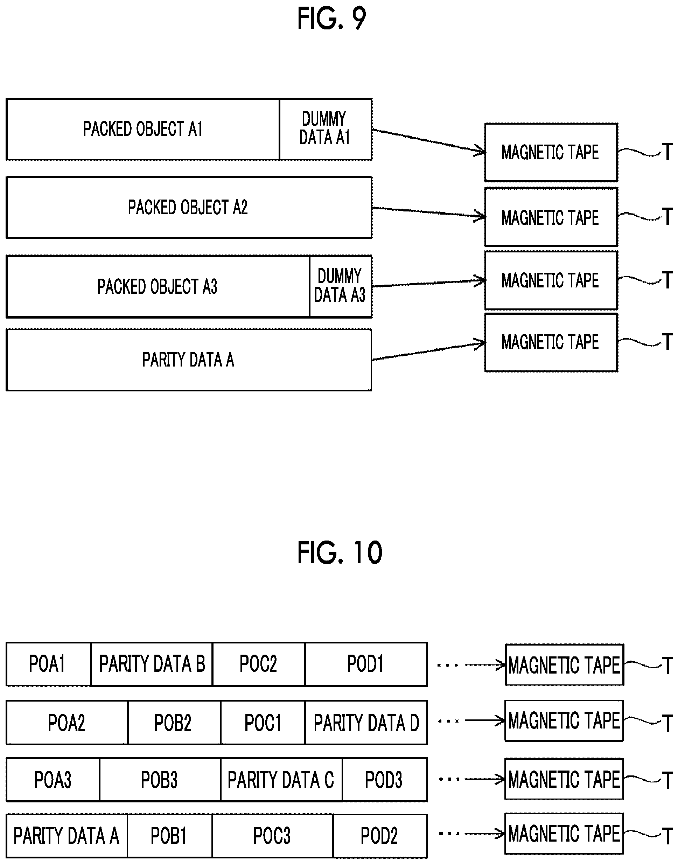

As illustrated in Fig. 8 as an example, the second generation unit 44 generates parity data for each of a plurality of sets of three packed objects. That is, a plurality of combinations of the three packed objects and the parity data exist. In Fig. 8, "dummy" represents dummy data. In addition, in Fig. 8, one-character alphabet following the "packed object", the "parity data", and the "dummy" is for identifying a combination of the three packed objects and the parity data. In addition, in Fig. 8, a numerical value following the one-character alphabet of the "packed object" and the "dummy" is for identifying the packed object and the dummy data in the combination. In Fig. 8, the notation rule is the same in Fig. 9, Fig. 10, and Fig. 12 to be described later.

As illustrated in Fig. 9 as an example, the selection unit 46 selects magnetic tapes T different from each other as recording destinations of each of the three packed objects and the parity data which are included in the same set. Further, the selection unit 46 selects magnetic tapes T as recording destinations of each of the three packed objects and the parity data from the plurality of magnetic tapes T such that a difference in sizes of pieces of the parity data to be recorded on each of the plurality of (in the present embodiment, four) magnetic tapes T is minimized. Specifically, as illustrated in Fig. 10 as an example, the selection unit 46 selects magnetic tapes T as recording destinations of the pieces of the parity data such that a difference in a total size of the pieces of the parity data to be recorded on each of the plurality of magnetic tapes T is minimized. In Fig. 10, "PO" represents the packed object and "parity" represents the parity data.

For example, the selection unit 46 can select the magnetic tapes T as recording destinations of each of the packed objects and each of the pieces of the parity data by solving a combinatorial optimization problem based on constraints such as (1) and (2) and an objective function such as (3).

(1) In each set, each of the packed objects and the parity data are recorded on the magnetic tapes T different from each other.
(2) Each of the packed objects and each of the pieces of the parity data are recorded on the magnetic tapes T at once.
(3) The difference in a total size of the pieces of the parity data to be recorded on each of the magnetic tapes T is minimized.

In this way, the magnetic tapes T different from each other are set as the recording destinations of each of the three packed objects and the parity data which are included in the same set. Thereby, even in a case where one magnetic tape T among four magnetic tapes T is lost, it is possible to recover the packed object.

The controller 48 performs a control of recording each of the three packed objects and the parity data, which are included in each of the plurality of sets, on the magnetic tapes T selected by the selection unit 46. In a case where a total value of the number of the packed objects and the number of the parity data in one set is set to be equal to or smaller than the number of the tape drives 18 that can be used at one time, the control can be performed in parallel.

In the present embodiment, in a case of performing the control, the controller 48 performs a control of recording only the packed objects among the packed objects and pieces of the dummy data added to the packed objects. Thereby, it is possible to prevent a decrease in available capacity of the magnetic tape T due to recording of the dummy data on the magnetic tape T.

In this case, in a case where one object of the three packed objects is lost, dummy data is added to the remaining two packed objects such that the sizes of the remaining two packed objects match the size of the parity data. Thereby, it is possible to recover the lost one packed object from the two packed objects to which the dummy data is added and the parity data.

In the present embodiment, in the case of performing the control, the controller 48 may also perform a control of recording the dummy data on the magnetic tape T. In this case, the dummy data addition processing in a case of recovering the packed object is not required.

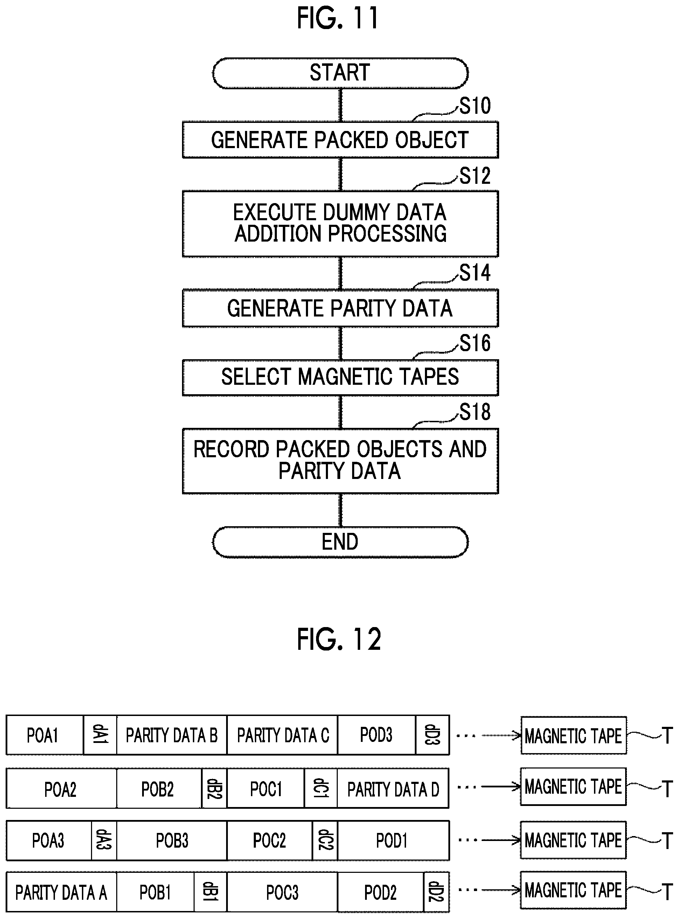

Next, an operation of the information processing apparatus 12 according to the present embodiment will be described with reference to Fig. 11. In a case where the CPU 20 executes the information processing program 30, data recording processing illustrated in Fig. 11 is executed. The data recording processing illustrated in Fig. 11 is executed, for example, in a case where object groups for generating a plurality of sets of three packed objects are stored in the storage unit 22.

In step S10 of Fig. 11, the first generation unit 40 generates a packed object obtained by grouping the plurality of objects stored in the storage unit 22 according to a packing rule, and stores the generated packed object in the storage unit 22. In step S 12, as described above, the execution unit 42 executes the dummy data addition processing on the plurality of packed objects stored in the storage unit 22 in step S10.

In step S14, as described above, the second generation unit 44 generates the parity data based on the plurality of packed objects to which the dummy data is added in step S12. In step S16, as described above, the selection unit 46 selects magnetic tapes T different from each other as recording destinations of each of the three packed objects and the parity data which are included in the same set. Further, as described above, the selection unit 46 selects magnetic tapes T as recording destinations of each of the three packed objects and the parity data from the plurality of magnetic tapes T such that a difference in sizes of the pieces of the parity data to be recorded on each of the plurality of magnetic tapes T is minimized.

In step S18, as described above, the controller 48 performs a control of recording each of the three packed objects and the parity data, which are included in each of the plurality of sets, on the magnetic tapes T selected in step S16. In a case where the processing of step S18 is completed, the data recording processing is completed.

The data included in the packed object may include data having a relatively high compression ratio, such as text data. Here, the compression ratio is represented by the following Equation (1). As the compression ratio has a larger numerical value, the data is further compressed.

$$\text{Compression Ratio} = ((\text{Data Size before Compression} - \text{Data Size after Compression})$$

$$\div \text{Data Size before Compression}) \times 100 \cdots (1)$$

On the other hand, the compression ratio of the parity data is relatively low. That is, a ratio of the size of the parity data to the size of all the pieces of the data on the magnetic tape T is relatively high. In the present embodiment, a difference in sizes of the pieces of the parity data to be recorded on each of the plurality of magnetic tapes T is set to be minimized. Therefore, it is possible to reduce a difference in a time required for recording data on each of the plurality of magnetic tapes T in a case where a plurality of pieces of data and parity data generated from the plurality of pieces of data are recorded on the plurality of magnetic tapes T.

In the present embodiment, a case where the selection unit 46 selects magnetic tapes T as recording destinations of each of the plurality of packed objects and the parity data from the plurality of magnetic tapes T such that a difference in sizes of the pieces of the parity data to be recorded on each of the plurality of magnetic tapes T is minimized has been described. On the other hand, the present invention is not limited thereto. The selection unit 46 may select magnetic tapes T as recording destinations of each of the plurality of packed objects and the parity data from the plurality of magnetic tapes T such that a difference in sizes of the pieces of the dummy data to be recorded on each of the plurality of magnetic tapes T is minimized.

Specifically, the selection unit 46 selects magnetic tapes T different from each other as recording destinations of each of the three packed objects and the parity data which are included in the same set. Further, as illustrated in Fig. 12 as an example, the selection unit 46 selects magnetic tapes T as recording destinations of each of the three packed objects and the parity data from the plurality of magnetic tapes T such that a difference in a total size of the pieces of the dummy data to be recorded on each of the plurality of magnetic tapes T is minimized. In Fig. 12, "PO" represents the packed object, "parity" represents the parity data, and "d" represents dummy data. Even in this case, as in the embodiment, the magnetic tapes T as recording destinations of the pieces of data can be obtained by solving a combinatorial optimization problem.

In the example, in a case of performing a control of recording each of the three packed objects and the parity data, which are included in each of the plurality of sets, on the magnetic tapes T selected by the selection unit 46, the controller 48 performs a control of recording the dummy data added to the packed object on the magnetic tape T. In the example, the dummy data is also recorded on the magnetic tape T, and thus the sizes of the parity data and each packed object including the dummy data in each set are the same size. Therefore, in a case where each packed object and the parity data in each set are recorded on the magnetic tapes T different from each other, a total size of all the data to be recorded on each magnetic tape T is the same. Here, the dummy data is data having a relatively high compression ratio, such as data padded with 0. That is, even in a case where the total size of all the data to be recorded on each magnetic tape T is the same, as a ratio of the dummy data to the total size of all the data is higher, a size of the data on the magnetic tape T (that is, a length of a portion in which the data is recorded on the magnetic tape T) is decreased. Thus, a time required for recording the data on the magnetic tape T is shortened. In the example, a difference in sizes of the pieces of the dummy data to be recorded on each of the plurality of magnetic tapes T is set to be minimized. Therefore, it is possible to reduce a difference in a time required for recording data on each of the plurality of magnetic tapes T in a case where a plurality of pieces of data and parity data generated from the plurality of pieces of data are recorded on the plurality of magnetic tapes T.

In addition, the example may be combined with the embodiment. In this case, the selection unit 46 selects magnetic tapes T as recording destinations of each of the three packed objects and the parity data from the plurality of magnetic tapes T such that a difference in sizes of the pieces of the parity data to be recorded on each of the plurality of magnetic tapes T is minimized and a difference in the size of the dummy data is minimized.

Further, in the embodiment, a case where the technique according to the present disclosure is applied to an object storage system has been described. On the other hand, the present disclosure is not limited thereto. The technique according to the present disclosure may be applied to a file storage system that handles data in file units.

Further, in the embodiment, for example, as a hardware structure of a processing unit that executes various processing, such as the first generation unit 40, the execution unit 42, the second generation unit 44, the selection unit 46, and the controller 48, the following various processors may be used. The various processors include, as described above, a CPU, which is a general-purpose processor that functions as various processing units by executing software (program), and a dedicated electric circuit, which is a processor having a circuit configuration specifically designed to execute a specific processing, such as a programmable logic device (PLD) or an application specific integrated circuit (ASIC) that is a processor of which the circuit configuration may be changed after manufacturing such as a field programmable gate array (FPGA).

One processing unit may be configured by one of these various processors, or may be configured by a combination of two or more processors of the same type or different types (for example, a combination of a plurality of FPGAs or a combination of a CPU and an FPGA). Further, the plurality of processing units may be configured by one processor.

As an example in which the plurality of processing units are configured by one processor, firstly, as represented by a computer such as a client and a server, a form in which one processor is configured by a combination of one or more CPUs and software and the processor functions as the plurality of processing units may be adopted. Secondly, as represented by a system on chip (SoC) or the like, a form in which a processor that realizes the function of the entire system including the plurality of processing units by one integrated circuit (IC) chip is used may be adopted. As described above, the various processing units are configured by using one or more various processors as a hardware structure.

Further, as the hardware structure of the various processors, more specifically, an electric circuit (circuitry) in which circuit elements such as semiconductor elements are combined may be used.

Further, in the embodiment, an example in which the information processing program 30 is stored (installed) in the storage unit 22 in advance has been described. On the other hand, the present disclosure is not limited thereto. The information processing program 30 may be provided by being recorded in a recording medium such as a compact disc read only memory (CD-ROM), a digital versatile disc read only memory (DVD-ROM), or a Universal Serial Bus (USB) memory. Further, the information processing program 30 may be downloaded from an external apparatus via a network.

Explanation of References

10: information processing system
12: information processing apparatus
14: tape library
18: tape drive
20: CPU
21: memory
22: storage unit
23: display
24: input device

25: network I/F
26: external I/F
27: bus
30: information processing program
40: first generation unit
42: execution unit
44: second generation unit
46: selection unit
48: controller
T: magnetic tape

**Claims**

1. An information processing apparatus that performs a control of recording a plurality of pieces of data on a plurality of magnetic tapes, the apparatus comprising:

   at least one processor,
   wherein the processor is configured to

   execute processing of making sizes of the plurality of pieces of data the same by adding dummy data to data other than data having a maximum size among the plurality of pieces of data,
   generate parity data based on the plurality of pieces of data to which the dummy data is added, and
   select the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

2. The information processing apparatus according to claim 1,
   wherein the processor is configured to select the magnetic tapes as the recording destinations of the plurality of pieces of data and the parity data from the plurality of magnetic tapes such that a difference in a size of the parity data to be recorded on each of the plurality of magnetic tapes is minimized.

3. The information processing apparatus according to claim 2,

   wherein a plurality of combinations of the plurality of pieces of data and the parity data exist, and
   the processor is configured to select the magnetic tapes different from each other as recording destinations of each of the plurality of pieces of data and the parity data in the same set, and select the magnetic tapes as recording destinations of each of pieces of the parity data such that a difference in a total size of the pieces of the parity data to be recorded on each of the plurality of magnetic tapes is minimized.

4. The information processing apparatus according to any one of claims 1 to 3,
   wherein the processor is configured to perform a control of recording only the data among the data and the dummy data added to the data in a case of performing the control of recording the data on the selected magnetic tapes.

5. The information processing apparatus according to any one of claims 1 to 3,
   wherein the processor is configured to select the magnetic tapes as the recording destinations of the plurality of pieces of data and the parity data from the plurality of magnetic tapes such that a difference in a size of the dummy data to be recorded on each of the plurality of magnetic tapes is minimized.

6. The information processing apparatus according to claim 5,
   wherein a plurality of combinations of the plurality of pieces of data and the parity data exist, and
   the processor is configured to select the magnetic tapes different from each other as recording destinations of each of the plurality of pieces of data and the parity data in the same set, and select the magnetic tapes as recording destinations of each of the plurality of pieces of data and the parity data from the plurality of magnetic tapes such that a difference in a total size of pieces of the dummy data to be recorded on each of the plurality of magnetic tapes is minimized.

7. The information processing apparatus according to any one of claims 1 to 6,

wherein the data to be recorded on the magnetic tapes is a packed object obtained by grouping a plurality of objects including data and metadata related to the data.

8. An information processing method executed by a processor of an information processing apparatus that includes at least one processor and performs a control of recording a plurality of pieces of data on a plurality of magnetic tapes, the method comprising:

executing processing of making sizes of the plurality of pieces of data the same by adding dummy data to data other than data having a maximum size among the plurality of pieces of data;
generating parity data based on the plurality of pieces of data to which the dummy data is added; and
selecting the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

9. A computer-readable storage medium storing an information processing program for an information processing apparatus including at least one processor and performing a control of recording a plurality of pieces of data on a plurality of magnetic tapes, the information processing program for causing the processor to execute a process comprising:

executing processing of making sizes of the plurality of pieces of data the same by adding dummy data to data other than data having a maximum size among the plurality of pieces of data;
generating parity data based on the plurality of pieces of data to which the dummy data is added; and
selecting the magnetic tapes as recording destinations of the plurality of pieces of data and the parity data from the plurality of magnetic tapes such that a difference in a size of at least one of the dummy data or the parity data to be recorded on each of the plurality of magnetic tapes is minimized.

# FIG. 1

TAPE LIBRARY

INFORMATION PROCESSING APPARATUS

TAPE DRIVE · · · TAPE DRIVE

# FIG. 2

OBJECT

| METADATA | DATA |
|----------|------|

## FIG. 3

| obj1 | obj2 | obj3 | obj4 | obj5 | obj6 | obj7 | obj8 | · · · |
|------|------|------|------|------|------|------|------|------|

PACKED OBJECT      PACKED OBJECT

## FIG. 4

CPU (20)   MEMORY (21)   DISPLAY (23)

STORAGE UNIT — INFORMATION PROCESSING PROGRAM (30) (22)   INPUT DEVICE (24)   NETWORK I/F (25)   EXTERNAL I/F (26)

27

12

# FIG. 5

**INFORMATION PROCESSING APPARATUS** 12

| 40 FIRST GENERATION UNIT | 42 EXECUTION UNIT | 44 SECOND GENERATION UNIT | 46 SELECTION UNIT | 48 CONTROLLER |

# FIG. 6

| PACKED OBJECT 1 | DUMMY DATA |

| PACKED OBJECT 2 |

| PACKED OBJECT 3 | DUMMY DATA |

12

## FIG. 7

| PACKED OBJECT 1 | DUMMY DATA |
| --- | --- |

| PACKED OBJECT 2 |
| --- |

| PACKED OBJECT 3 | DUMMY DATA |
| --- | --- |

| PARITY DATA |
| --- |

## FIG. 8

| SAME SET | | SAME SET | |
| --- | --- | --- | --- |
| PACKED OBJECT A1 | DUMMY DATA A1 | PACKED OBJECT B1 | DUMMY DATA B1 |
| PACKED OBJECT A2 | | PACKED OBJECT B2 | DUMMY DATA B2 |
| PACKED OBJECT A3 | DUMMY DATA A3 | PACKED OBJECT B3 | |
| PARITY DATA A | | PARITY DATA B | |

. . .

FIG. 9

| PACKED OBJECT A1 | DUMMY DATA A1 |
| --- | --- |

→ MAGNETIC TAPE ～T

| PACKED OBJECT A2 |
| --- |

→ MAGNETIC TAPE ～T

| PACKED OBJECT A3 | DUMMY DATA A3 |
| --- | --- |

→ MAGNETIC TAPE ～T

| PARITY DATA A |
| --- |

→ MAGNETIC TAPE ～T

FIG. 10

| POA1 | PARITY DATA B | POC2 | POD1 |
| --- | --- | --- | --- |

· · · → MAGNETIC TAPE ～T

| POA2 | POB2 | POC1 | PARITY DATA D |
| --- | --- | --- | --- |

· · · → MAGNETIC TAPE ～T

| POA3 | POB3 | PARITY DATA C | POD3 |
| --- | --- | --- | --- |

· · · → MAGNETIC TAPE ～T

| PARITY DATA A | POB1 | POC3 | POD2 |
| --- | --- | --- | --- |

· · · → MAGNETIC TAPE ～T

# FIG. 11

```
           START
             |
             |  ~S10
  ┌──────────────────────┐
  │ GENERATE PACKED OBJECT │
  └──────────────────────┘
             |
             |  ~S12
  ┌──────────────────────┐
  │    EXECUTE DUMMY DATA  │
  │   ADDITION PROCESSING  │
  └──────────────────────┘
             |
             |  ~S14
  ┌──────────────────────┐
  │  GENERATE PARITY DATA  │
  └──────────────────────┘
             |
             |  ~S16
  ┌──────────────────────┐
  │  SELECT MAGNETIC TAPES │
  └──────────────────────┘
             |
             |  ~S18
  ┌──────────────────────┐
  │ RECORD PACKED OBJECTS AND │
  │      PARITY DATA       │
  └──────────────────────┘
             |
            END
```

# FIG. 12

| POA1 | dA1 | PARITY DATA B | PARITY DATA C | POD3 | dD3 | · · · | → | MAGNETIC TAPE | ~T |
| POA2 | | POB2 | dB2 | POC1 | dC1 | PARITY DATA D | · · · | → | MAGNETIC TAPE | ~T |
| POA3 | dA3 | POB3 | | POC2 | dC2 | POD1 | · · · | → | MAGNETIC TAPE | ~T |
| PARITY DATA A | | POB1 | dB1 | POC3 | | POD2 | dD2 | · · · | → | MAGNETIC TAPE | ~T |

Europäisches
Patentamt

European
Patent Office

Office européen
des brevets

# EUROPEAN SEARCH REPORT

Application Number

EP 23 15 7510

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/246886 A1 (UCHIYAMA KENJI [JP]) 19 September 2013 (2013-09-19) * abstract * * paragraphs [0121] - [0145] * * figures 9-12 * | 1-9 | INV. G11B20/12 G06F3/06 G06F11/10 G11B17/22 G11B27/00 |
| X | US 2014/281796 A1 (UCHIYAMA KENJI [JP]) 18 September 2014 (2014-09-18) * abstract * * paragraphs [0121] - [0135] * * figure 10 * | 1-9 | |
| X | US 2015/220397 A1 (UCHIYAMA KENJI [JP]) 6 August 2015 (2015-08-06) * abstract * * paragraphs [0114] - [0129] * * figures 9,10 * | 1-9 | |
| A | WO 01/22224 A2 (STORAGE TECHNOLOGY CORP [US]) 29 March 2001 (2001-03-29) * the whole document * | 1-9 | TECHNICAL FIELDS SEARCHED (IPC) |
| T | KOJI MATSUMURA ET AL: "Object-based Tape Storage System in Managing the Exponential Data Growth", PROCEEDINGS OF THE 2020 GENERAL CONFERENCE OF THE INSTITUTE OF ELECTRONICS, INFORMATION AND COMMUNICATION ENGINEERS ELECTRONICS 2; IEICE GENERAL CONFERENCE; (HIGASHIHIROSHIMA): 2020.03.17-20 EIC/DENSHI JOHO TSUSHIN GAKKAI SOGO TAIKAI, 3 March 2020 (2020-03-03), pages S5-S6, XP009539684, | | G11B G06F |

The present search report has been drawn up for all claims

| Place of search | Date of completion of the search | Examiner |
|---|---|---|
| Munich | 3 July 2023 | Sucher, Ralph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 7510

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2023

| Patent document cited in search report | | Publication date | Patent family member(s) | | Publication date |
|---|---|---|---|---|---|
| US 2013246886 | A1 | 19-09-2013 | JP | 5942512 B2 | 29-06-2016 |
| | | | JP | 2013196318 A | 30-09-2013 |
| | | | US | 2013246886 A1 | 19-09-2013 |
| US 2014281796 | A1 | 18-09-2014 | JP | 6073717 B2 | 01-02-2017 |
| | | | JP | 2014182460 A | 29-09-2014 |
| | | | US | 2014281796 A1 | 18-09-2014 |
| US 2015220397 | A1 | 06-08-2015 | JP | 6225731 B2 | 08-11-2017 |
| | | | JP | 2015143952 A | 06-08-2015 |
| | | | US | 2015220397 A1 | 06-08-2015 |
| WO 0122224 | A2 | 29-03-2001 | AU | 7593700 A | 24-04-2001 |
| | | | US | 6532548 B1 | 11-03-2003 |
| | | | WO | 0122224 A2 | 29-03-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021117772 A
- JP 2015143952 A